# EUROPEAN PATENT APPLICATION

(11) **EP 1 463 390 A2**
(43) Date of publication of application: **29.09.2004**
(21) Application number: 04251826.6
(22) Date of filing: 26.03.2004
(51) Int. Cl.: H05K 3/34, H05K 13/08

(54) **Soldering method and apparatus**

(30) Priority: 27.03.2003 GB 0307105
(71) Applicant: PILLARHOUSE INTERNATIONAL LIMITED, Chelmsford, Essex CM1 3BY (GB)
(72) Inventor: Ciniglio, Alexander James, Great Dunmow CM6 1JH Essex (GB)
(74) Representative: Luckhurst, Anthony Henry William

(57) **Abstract**

A soldering apparatus includes an inspection station I downstream of the soldering station D. A board PCB2 is collected from conveyor A, soldered at station D and returned to conveyor A, while a previously soldered board PCB2 is inspected at station I. If PCB1 board fails inspection at station I, PCB2 is moved from conveyor A to conveyor B, so that PCB1 can be moved back on to conveyor A, for collection and re-soldering at station D. PCB2 can then be moved forwards for inspection at station I.

## Description

The present invention relates to a soldering method and apparatus, and in particular to a soldering method and apparatus for automatically re-soldering faulty joints in a production process.

It is known to provide an automated optical inspection of printed circuit board assemblies after soldering, for example after passing a board loaded with components through a wave soldering apparatus. The joints on the underside of the board are pictured and compared to an optimal picture to identify joints which may need re-soldering. Thus it is possible to identify dry joints, solder bridging, and the like.

In prior art systems, a board identified as having a faulty joint is removed from the production line and passed to an operator to re-solder the joints by hand.

We provide selective soldering apparatus, particularly a flow soldering apparatus, in which components are soldered to printed circuit boards (PCBs) at discrete locations on the board. In some apparatus, the board is lowered over a multiplicity of solder nozzles positioned below the components being soldered. In other apparatus, a single nozzle may be used and the components soldered in turn, the board being translated relative to the nozzle between dipping operations.

Typically a board is delivered to the soldering apparatus on a conveyor. It may first pass through a fluxing station and/or a pre-heat station. The board is then lifted from the conveyor by an XYZ carriage which carries the board during the soldering operation and then deposits the board back on the conveyor.

We have realised that it is possible to return a faulty board automatically into the production line, to re-solder all or some of the solder joints.

Thus a first aspect of the invention provides a soldering method comprising soldering a component to a printed circuit board using a selective soldering apparatus, automatically inspecting the board to detect the presence of a faulty joint, and automatically returning the board to the soldering apparatus to remedy the defect. Preferably the inspection identifies which joints are, or are likely to be, faulty.

When the board is returned to the soldering apparatus, all the joints may be re-soldered, or preferably only joints identified as being faulty, or components having faulty joints. A single point soldering apparatus may be used to re-solder only those joints which are faulty.

Preferably a board is inspected while another board is being soldered. Means may then be provided for an inspected, faulty board and the other board to pass one another in the production line, to re-solder the faulty board while the other board is being inspected.

A second aspect of the invention provides a soldering apparatus comprising:
a container for molten solder;
a conveyor for a printed circuit board;
a carriage for moving a said circuit board from the conveyor to the container to dip leads to be soldered into the solder in the container to form soldered joints and returning the circuit board to the conveyor;
means for automatically inspecting a soldered joint to determine if the joint does not meet requirements, and
means for automatically returning the board to the carriage if the joint does not meet requirements.

Preferably the board is inspected by the automatic inspecting means while the board is on the conveyor. Preferably the board is moved by the conveyor to an inspecting position where it is inspected by the inspecting means. The board is then inspected. The conveyor may then be reversed, to return the board to the carriage. If the joints on a board meet requirements, the board may continue on to the next stage of the production process.

Preferably the conveyor comprises two or more conveyor sections, which are operable independently to convey a board along the respective section.

At a first position on the conveyor a board is collected by the carriage for soldering, and returned. At a second position, upstream of the first position, a board can be temporarily stored while a board which is to be re-soldered is returned for collection by the carriage.

Thus a board may be inspected at a downstream part of the conveyor and conveyed back for collection by the carriage if a fault is detected. When a board is to be conveyed back, there will be another board, upstream, which has been soldered and is ready to be deposited on the carriage for passing to the inspection station, and other boards further upstream, to be soldered. It is necessary to hold these upstream boards while the previously soldered board, with a fault, is moved back for collection by the carriage. This can be achieved in various ways.

We prefer that when a board is to be collected by the carriage, it is moved to a return position, ensuring that the board is correctly positioned. We also prefer that the board is returned to the same position for onward movement to the inspection station. Typically a board will carry fiducial marks so that the position and orientation of the board relative to the soldering apparatus can be determined when the board is collected by the XYZ carriage.

Thus, in a preferred apparatus and process, if a board requires re-soldering, the board which is upstream (the upstream board) which has just been soldered is deposited on the conveyor and then moved upstream on the conveyor, i.e. upstream of the return position, so that the board to be re-soldered can be moved by the conveyor into the return position for collection by the carriage. After collection of the board to be re-soldered, the upstream board can be moved downstream to the inspection station.

In another embodiment, the board to be re-soldered may be moved upstream of the return position, the upstream board deposited at the return position, and then both boards moved downstream, respectively to the return position and the inspection station.

In yet another embodiment, the upstream board may be returned to the conveyor upstream of the return position, to allow the board to be re-soldered to be conveyed back to the return position.

All of these procedures are greatly facilitated if the conveyor in the vicinity of the carriage is in two, independently operable sections, a downstream section incorporating the return position, and an upstream section upstream of the downstream section.

It will be appreciated that a re-soldered board is passed back to the inspection station. If the board fails the inspection it may be returned again for re-soldering. In one embodiment a board is returned for re-soldering only a limited number of times, preferably three. After the limit is reached an alarm may sound, for example, for the board to be removed or flagged for manual inspection.

Some manufacturing processes specify the conditions to be met when soldering and re-soldering. Thus fluxing and/or pre-heating may be specified requirements, even when re-soldering. Thus, in one embodiment we provide for the board to be re-soldered to be passed back to the fluxing and/or pre-heating station. The speed of the soldering process is usually the rate limiting step in the production of soldered boards. In this event, the fluxing and/or pre-heating stations may be kept clear until the inspection of a board is completed, and a new board is fed to these stations only if the inspection is passed. Otherwise, the stations remain clear for a board for re-soldering to be passed upstream through to the fluxing and/or pre-heating stations.

In another embodiment, we provide a second fluxing and/or pre-heating station at the soldering station. Preferably this is adapted to provide localised fluxing or heating of the joints to be re-soldered.

When re-soldering, the complete soldering operation may be performed again. However, when particular joints which are faulty are identified (as opposed to simply detecting that the board has a fault), we prefer to re-solder only those joints, or components incorporating a joint where a fault is identified. Where a board is dipped simultaneously into several solder nozzles, this may not be possible. Thus, in another embodiment, we provide a localised soldering apparatus, adjacent the dip-soldering apparatus, to solder only those joints which are detected as being faulty. This localised soldering apparatus may be a point soldering apparatus, or a small pot for dip soldering. Such apparatus are known per se.

Other features and advantages of the present invention will be apparent from the following description of the preferred embodiments and the accompanying claims.

The invention will be further described by way of example with reference to the accompanying drawings, in which:
Figure 1 illustrates a first embodiment of a soldering process in accordance with the invention,
Figure 2 shows a modification of the embodiment of Figure 1, and
Figure 3 shows a side view of an apparatus forming an embodiment of the invention.

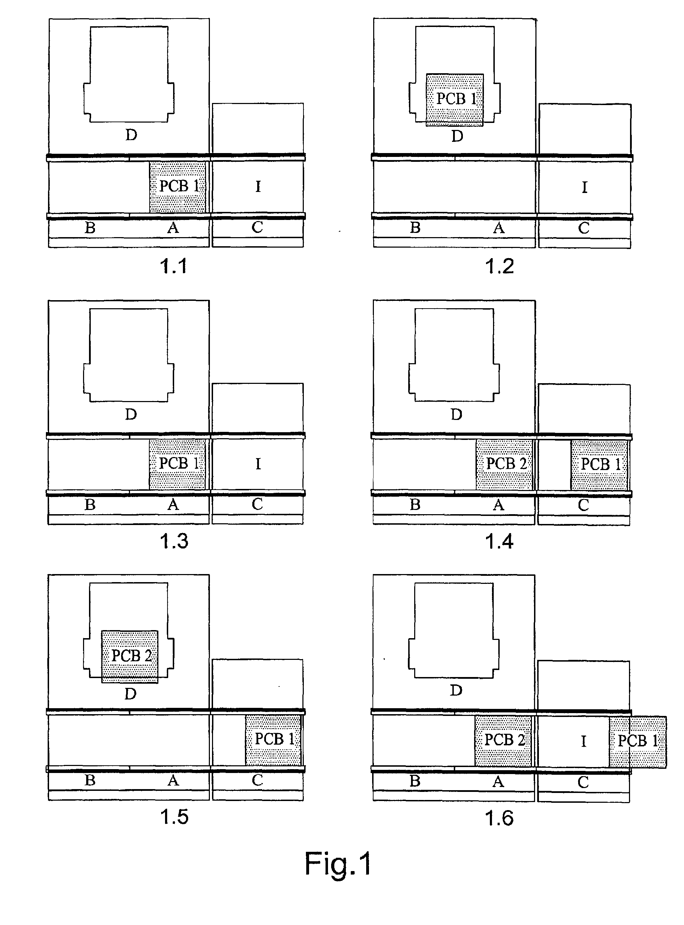

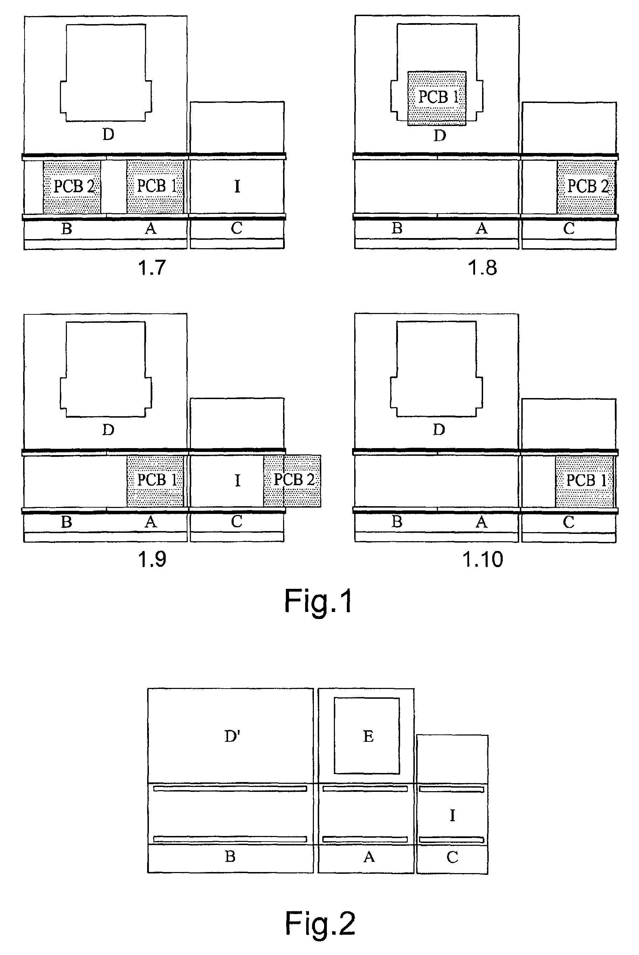

Referring to Figure 1, this shows various stages of a soldering process using the inspection and return system of the invention. Only the main stages of the process are shown here, but it will be appreciated by those in the art that additional steps such as fluxing and heating may be incorporated in the process.

Shown in Figure 1 is a soldering station D which incorporates an XYZ carriage for lifting a printed circuit board (PCB) to be soldered from a conveyor A to dip leads on the underside of a board into a solder bath or solder nozzles as well known in the art. One such apparatus is marketed by us under the brand name Topaz. Conveyor A denotes a 'return' position. Also shown is a second conveyor B upstream of conveyor A, and an inspection station I downstream of conveyor A.

Inspections station I has a conveyor C having a camera underneath the conveyor. To inspect a board, the camera is focussed on the underside of the board and is scanned under the board on an XY carriage. The pictures of the soldered joints are compared to a stored picture of a 'good' board and any significant discrepancy is flagged as a faulty joint. Such systems are well known in the art. The position of a faulty joint, relative to the fiducial marks on the board, is noted, and the information stored for use in the re-soldering operation.

Turning to Figures 1.1 to 1.3 these show a board PCB1 on conveyor A ready for collection, being soldered in station D and subsequently returned to conveyor A. The normal direction of travel is left to right in the figures.

At figure 1.4, PCB1 is moved to inspection station I, being fed on to conveyor C and a second board PCB2 moved to the collection position on conveyor A (having been fed across conveyor B). At figure 1.5, PCB2 is soldered while PCB1 is inspected. Thus it can be seen that the inspection process does not slow down the soldering process. Usually the soldering process will be the rate determining step.

At figure 1.5, if PCB1 passes inspection it is moved on, and replaced by PCB2 which has been placed on conveyor A.

However, if PCB1 fails inspection, conveyors B, A and C are reversed to move board PCB2 to conveyor B, and board PCB 1 to the return position, on conveyor A. At figure 1.8, PCB1 has been collected from conveyor A by the soldering station D and is being re-soldered, while PCB2 has been forwarded to the inspection station I and is being inspected at station I.

At figure 1.9, if PCB2 passes inspection, it moves downstream and PCB1 then moves on to the inspection station I (figure 1.10), o be inspected again.

It will be appreciated that a third board (not shown) is introduced at step 1.6 as PCB2 moves to station I (when PCB1 has passed inspection), being fed across conveyor B to conveyor A. Similarly, at step 1.10 a third board is also moved to conveyor A as PCB1 moves to conveyor C.

To perform a re-soldering operation, the board may be completely re-soldered. However, we prefer to incorporate single point soldering apparatus in station D to effect soldering of only the joints identified, by station I, as being defective. Station D may also incorporate a local fluxing station and or heating station if desired.

It will be appreciated that other arrangements are possible. Thus, for example, at steps 1.5/1.7, PCB2 may be held in station D while PCB1 is returned, by reversing the conveyors, to conveyor B. PCB2 may then be deposited on conveyor A, and conveyors B and A moved forwards to convey PCB1 and PCB2 respectively to conveyor A (for collection and re-soldering) and to station I for inspection. In another variation, PCB2 is deposited on conveyor A, and the conveyors reversed to move PCB2 to conveyor B and PCB1 to conveyor A. PCB1 is then collected for re-soldering, and PCB2 moved forwards to station I.

By using separate conveyors, particularly conveyors A and B, it is possible to ensure that boards do not meet. Usually a conveyor is controlled so that it will not operate to move a board onto the adjacent conveyor until the adjacent conveyor is clear.

In place of station D, a multi point dip soldering apparatus D' may be placed beside a single point soldering apparatus E, so that a board is returned to the single point soldering apparatus only, as illustrated in Figure 2. Apparatus D' will collect a board from conveyor B and return the soldered board to conveyor B. This allows another option in which, when a board is to be re-soldered, the upstream board may be held at B, until the downstream board is returned to A and collected by single point soldering apparatus E, whereupon conveyor A is clear, and the upstream board can proceed through to station I.

It will be appreciated that the apparatus is computer controlled. The system will be aware if a particular board is returned for re-soldering more than once, and an alarm may sound if a board fails inspection more than three times, for example, so that the board can be collected by an operator. This can typically happen if, for example, a component is missing from a board or a lead has not passed through the board.

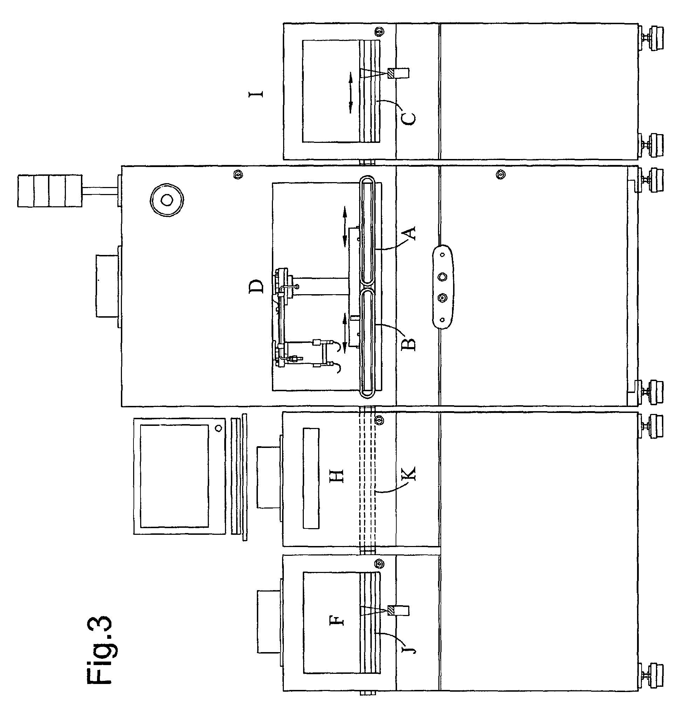

Figure 3 shows an apparatus having a fluxing station F and a heating station H upstream of the soldering station D and inspection station I. As known in the art, each station has a conveyor J, K, B - A, and C respectively. The conveyors are aligned to enable a board to be passed from one conveyor to the adjacent one. Detector and control circuitry ensure that a board is not passed onto an adjacent conveyor until it is clear.

In a typical soldering operation a board is passed through the fluxing station F, then preheat station H and into the soldering station D for soldering. Stations D and I, and the associated conveyors A, B, C may operate as described for figure 1. Typically a board will not be fed into the pre-heat station until station D is ready to receive a board for soldering. Otherwise a board may be held in the pre-heat station too long. Thus, it is possible to convey a board, which is to be re-soldered, back into the pre-heat station, when a board must be re-heated before being re-soldered. Similarly, if entry into the fluxing station is delayed until station D is clear, a board could be backed up to the fluxing station and then moved forwards for re-soldering. In another embodiment, a localised fluxing and/or heating unit could by provided in station D.

## Claims

1. A soldering method comprising soldering a component to a printed circuit board using a selective soldering apparatus at a soldering station, automatically inspecting the board to detect the presence of a faulty joint, and automatically returning the board to the soldering station to re-solder the faulty joint.

2. A soldering method as claimed in claim 1, wherein the inspection is an optical inspection.

3. A soldering method as claimed in claim 1 or 2, wherein the inspection identifies which joints are, or are likely to be, faulty.

4. A soldering method as claimed in claim 3, wherein when the board is returned to the soldering station only joints identified as being faulty, or components having faulty joints, are re-soldered.

5. A soldering method as claimed in any one of claims 1 to 5, wherein a board is inspected while another board is being soldered.

6. A soldering method as claimed in any one of claims 1 to 5, wherein an inspected board and an upstream board pass one another in the production line, when the inspected board is re-soldered.

7. A soldering method as claimed in claim 6, wherein a board is moved on a conveyor to a return position and collected from the conveyor by a carriage at the soldering station.

8. A soldering method as claimed in claim 7, wherein the board is returned to the return position after soldering.

9. A soldering method as claimed in claim 7 or 8, wherein, if a board requires re-soldering, the board which is upstream (the upstream board) and has just been soldered is deposited on the conveyor and then moved upstream on the conveyor, upstream of the return position, so that the board to be re-soldered can be moved by the conveyor into the return position for collection by the carriage.

10. A soldering method as claimed in claim 9, wherein after collection of the board to be re-soldered, the upstream board is moved downstream to the inspection station.

11. A soldering method as claimed in claim 8, wherein the board to be re-soldered is moved upstream of the return position, the upstream board is deposited at the return position, and then both boards are moved downstream, respectively to the return position and the inspection station.

12. A soldering method as claimed in claim 8, wherein a soldered board is returned to the conveyor upstream of the return position, and a board to be re-soldered is conveyed back to the return position for collection by the carriage.

13. A soldering method as claimed in any one of claims 1 to 12, wherein a re-soldered board is passed back to the inspection station, and a board is returned for re-soldering only a maximum pre-determined number of times.

14. A soldering method as claimed in any one of claims 1 to 13, wherein a board to be re-soldered to be passed back to a fluxing and/or pre-heating station before re-soldering.

15. A soldering method as claimed in claim 14, wherein the fluxing and/or pre-heating stations are kept clear until the inspection of a board is completed, and a new board is fed to these stations only if the inspection is passed.

16. A soldering method as claimed in any one of claims 1 to 14, wherein a board is soldered at a first dip soldering apparatus, and re-soldered at a second soldering apparatus at the soldering station.

17. A soldering apparatus comprising:
a container for molten solder;
a conveyor for a printed circuit board;
a carriage for moving a said circuit board from the conveyor to the container to dip leads to be soldered into solder in the container to form soldered joints and returning the circuit board to the conveyor;
means for automatically inspecting a soldered joint to determine if the joint does not meet requirements; and
means for automatically returning the board to the carriage if a joint does not meet requirements.

18. Apparatus as claimed in claim 17, wherein the automatic inspecting means is arranged to inspect the board while the board is on the conveyor.

19. Apparatus as claimed in claim 17 or 18, wherein the conveyor is adapted to convey the board in forward and reverse directions, the conveyor being reversed to return the board to the carriage.

20. Apparatus as claimed in any one of claims 17, 18 or 19, wherein the inspection means is operable to inspect a board while another board is being soldered.

21. Apparatus as claimed in any one of claims 17 to 20, wherein means is provided for moving an inspected board past an upstream soldered board.

22. Apparatus as claimed in claim 21, wherein a return position is provided on the conveyor and control means is provided to move the board to the a return position for collection by the carriage.

23. Apparatus as claimed in claim 22, wherein the conveyor comprises two adjacent conveyor sections, which are operable independently to convey a board along the respective section, and the return position is provided on the downstream section.

24. Apparatus as claimed in claim 22 or 23, wherein control means is provided to return the board to the return position after soldering.

25. Apparatus as claimed in claim 22, 23 or 24, wherein control means is provided for controlling the carriage to deposit a soldered board on the conveyor and controlling the conveyor to move the deposited board upstream on the conveyor, and moving a board to be re-soldered into the return position for collection by the carriage.

26. Apparatus as claimed in claim 24, wherein control means is provided to control the conveyor to move a board to be re-soldered upstream of the return position, controlling the carriage to deposit the upstream board at the return position, and then controlling the carriage to move both boards downstream, respectively to the return position and the inspecting means.

27. Apparatus as claimed in claim 22 or 23, wherein control means is provided to control the carriage to return a board to the conveyor upstream of the return position, to control the conveyor to move a board to be re-soldered back to the return position.

28. Apparatus as claimed in any one of claims 17 to 27, wherein control means is provided to limit the number of times a board is returned for re-soldering.

29. Apparatus as claimed in any one of claims 17 to 28, wherein fluxing and/or pre-heating means are provided, and control means is provided to convey a board to be re-soldered back to the fluxing and/or pre-heating means.

30. Apparatus as claimed in claim 29, wherein control means is provided to keep the fluxing and/or pre-heating means clear until the inspection of a board is completed, and to feed a new board to these stations only if the inspection is passed.
